# EUROPEAN PATENT APPLICATION

(11) **EP 4 719 034 A2**
(43) Date of publication of application: **01.04.2026**
(21) Application number: 25196503.4
(22) Date of filing: 18.08.2025
(51) Int. Cl.: H10W 42/00, H10W 40/00, H10W 70/02, H10W 70/05, H10W 72/90, H10W 90/00, H10W 99/00

(54) **METHODS OF FABRICATING PACKAGE STRUCTURES INCLUDING A HERMETIC COMPRESSIVE CAPPING LAYER FOR LID ATTACH WITH GAP-FILL OXIDE**

(30) Priority: 27.09.2024 US 202418900384
(71) Applicant: Intel Corporation, Santa Clara, CA 95054 (US)
(72) Inventor: HASAN, Md Mahbubul, Portland, 97229 (US); BRUN, Xavier F., Chandler, 85224 (US)
(74) Representative: HGF

(57) **Abstract**

Microelectronic integrated circuit package structures include a package structure comprising a first die on a first dielectric material and a second die on second dielectric material, where the first die is adjacent to the second die. A third die is below the first die and is hybrid bonded to the first die. a fourth die is below the second die, and is hybrid bonded to the second die. A layer comprising nitrogen and silicon is directly on top surfaces of the first die and the second die. A fill dielectric material is between the first die and the second die, and a lid over the fill dielectric material.

## Description

### BACKGROUND

In electronics manufacturing, integrated circuit (IC) packaging is a stage of manufacture where an IC that has been fabricated on a die or chip comprising a semiconducting material is coupled to a supporting case or "package" that can protect the IC from physical damage and support electrical interconnect suitable for further connecting to a host component, such as a printed circuit board (PCB). In the IC industry, the process of fabricating a package is often referred to as packaging, or assembly.

In a hybrid bonding packaging application, one or more top die may be hybrid bonded to a base die or collective base dies that may be below the top die. There may be a gap, or die to die spacing, that is between the top dies. This space may be filled with a gap fill material, such as a silicon dioxide material for example. The space between the dies can range between a few microns to several millimeters. Current fill materials may exhibit shrinkage (and possible outgassing) during temperature processing that can create issues during a structural silicon (thermal mechanical structural (TMS) Silicon) lid attach process. Degassing prior to TMS lid attach process can address long range voids (large voids), however, sidewall oxide shrinkage resulting from degassing can lead to a surface dip and eventually die to die spacing voids between the gap fill material and the lid. Addressing these two competing phenomena has proven to be challenging.

### BRIEF DESCRIPTION OF THE DRAWINGS

The subject matter described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1A is a cross-sectional view of a multichip device including a capping layer on a gap fill dielectric material, in accordance with some embodiments.
FIG. 1B is a cross-sectional view of a multichip device including two capping layers on a gap fill dielectric material, in accordance with some embodiments.
FIG. 1 C is cross-sectional view of a multichip device including a gap fill dielectric material, in accordance with some embodiments.
FIGS. 2A-2H are cross-sectional views of methods of forming multichip device structures including a capping layer on a gap fill dielectric material, in accordance with some embodiments.
FIGS. 3A-3D are cross-sectional views of methods of forming multichip device structures including two capping layers on a gap fill dielectric material, in accordance with some embodiments.
FIGS. 4A-4C are cross-sectional views of methods of forming multichip device structures including a gap fill dielectric material, in accordance with some embodiments.
FIG.5 is a cross-sectional view of an IC package structure comprising a multichip device structure including a capping layer on a gap fill dielectric material, in accordance with some embodiments.
FIG. 6 illustrates a flow chart of a processes for the fabrication of IC package structures having a capping layer on a gap fill dielectric material, in accordance with some embodiments.
FIG. 7 is a functional block diagram of an electronic computing device, in accordance with some embodiments of the present disclosure.

### DETAILED DESCRIPTION

Embodiments are described with reference to the enclosed figures. While specific configurations and arrangements are depicted and discussed in detail, it should be understood that this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. It should be understood that these terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements cooperate or interact with each other (e.g., as in a cause and effect relationship).

The terms "over," "under," "between," and "on" as used herein refer to a relative position of one component or material with respect to other components or materials where such physical relationships are noteworthy. For example in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct physical contact with that second material/layer. Similar distinctions are to be made in the context of component assemblies.

As used throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C.

Unless otherwise specified in the explicit context of use, the term "predominantly" means more than 50%, or more than half. For example, a composition that is predominantly a first constituent means more than half of the composition is the first constituent (e.g., <50 at. %). The term "primarily" means the most, or greatest, part. For example, a composition that is primarily a first constituent means the composition has more of the first constituent than any other constituent.

The term "package" generally refers to a self-contained carrier of one or more dice, where the dice are attached to the package substrate, and may be encapsulated for protection, with integrated or wire-bonded interconnects between the dice and leads, pins or bumps located on the external portions of the package substrate. The package may contain a single die, or multiple dice, providing a specific function. The package is usually mounted on a printed circuit board for interconnection with other packaged integrated circuits and discrete components, forming a larger circuit.

The term "dielectric" generally refers to any number of non-electrically conductive (electrically non-conductive?) materials that make up the structure of a package substrate.

The term "metallization" generally refers to metal layers formed over and through the dielectric material of the package substrate. The metal layers are generally patterned to form metal structures such as traces and bond pads. The metallization of a package substrate may be confined to a single layer or in multiple layers separated by layers of dielectric.

The term "bond pad" generally refers to metallization structures that terminate integrated traces and vias in integrated circuit packages and dies. The term "solder pad" may be occasionally substituted for "bond pad" and carries the same meaning.

The term "solder bump" generally refers to a solder layer formed on a bond pad. The solder layer typically has a round shape, hence the term "solder bump".

The term "substrate" generally refers to a planar platform comprising dielectric and metallization structures. The substrate mechanically supports and electrically couples one or more IC dies on a single platform, with encapsulation of the one or more IC dies by a moldable dielectric material. The substrate generally comprises solder bumps as bonding interconnects on both sides. One side of the substrate, generally referred to as the "die side", comprises solder bumps for chip or die bonding. The opposite side of the substrate, generally referred to as the "land side", comprises solder bumps for bonding the package to a printed circuit board.

The vertical orientation is in the z-direction and it is understood that recitations of "top", "bottom", "above" and "below" refer to relative positions in the z-dimension with the usual meaning. However, it is understood that embodiments are not necessarily limited to the orientations or configurations illustrated in the figure.

The terms "substantially," "close," "approximately," "near," and "about," generally refer to being within +/- 10% of a target value (unless specifically specified). Unless otherwise specified the use of the ordinal adjectives "first," "second," and "third," etc., to describe a common object, merely indicate that different instances of like objects to which are being referred and are not intended to imply that the objects so described must be in a given sequence, either temporally, spatially, in ranking or in any other manner.

Views labeled "cross-sectional", "profile" and "plan" correspond to orthogonal planes within a Cartesian coordinate system. Thus, cross-sectional and profile views are taken in the x-z plane, and plan views are taken in the x-y plane. Typically, profile views in the x-z plane are cross-sectional views. Where appropriate, drawings are labeled with axes to indicate the orientation of the figure.

Embodiments discussed herein address problems associated with packaging architectures and methods utilizing a hermetic capping layer to address die to die gap fill oxide material voids within the distance between top dies of a multichip hybrid bonded device. The distance between the top dies can range from tens of microns to several millimeters. A plasma enhanced chemical vapor deposition (PECVD) oxide materials may be used since they possess a relatively high deposition rate however, the gap fill oxide material may undergo shrinkage (and possible outgassing) at high process temperatures at top die sidewall locations.

Degassing the gap fill oxide prior to a lid attach process can address long range voids in the gap fill oxide material, however top die sidewall oxide shrinkage can lead to a gap fill surface dip and die to die spacing voids between the gap fill oxide and an attached lid. Utilizing the methods and structures included herein prevent the formation of spacing voids and shrinkage at die sidewalls. The hermetic capping layers described herein prevent the formation of voids and shrinkage. Additionally, if the hermetic layer is a compressive capping layer such as a SiNx capping layer, it provides a wafer bow compensation/tuning capability of the wafer profile during processing. Also, a higher temperature lid attach process is enabled which suppresses oxide shrinkage and outgassing.

The embodiments herein include methods of utilizing a hermetic compressive capping layer for successful lid attach with gap-fill oxide in a multichip stacked device. In an embodiment, a multichip stacked device may comprise a single hermetic capping layer where a bow compensation may be optimized. In another embodiment, two capping layers may be used such as a hermetic SiNx first capping layer and a PECVD oxide second capping layer on the first capping layer. In yet another embodiment, a densified oxide gap fill material may be used to act as the bonding layer with a lid (in this case, no capping layer is needed).

The architectures described herein may be assembled and/or fabricated with one or more of the features or attributes provided in accordance with various embodiments. A number of different assembly and/or fabrication methods may be practiced to enable the incorporation of hermetic capping layers such as SiNx which prevent voids in gap fill oxide films between top dies in a multichip device, according to one or more of the features or attributes described herein.

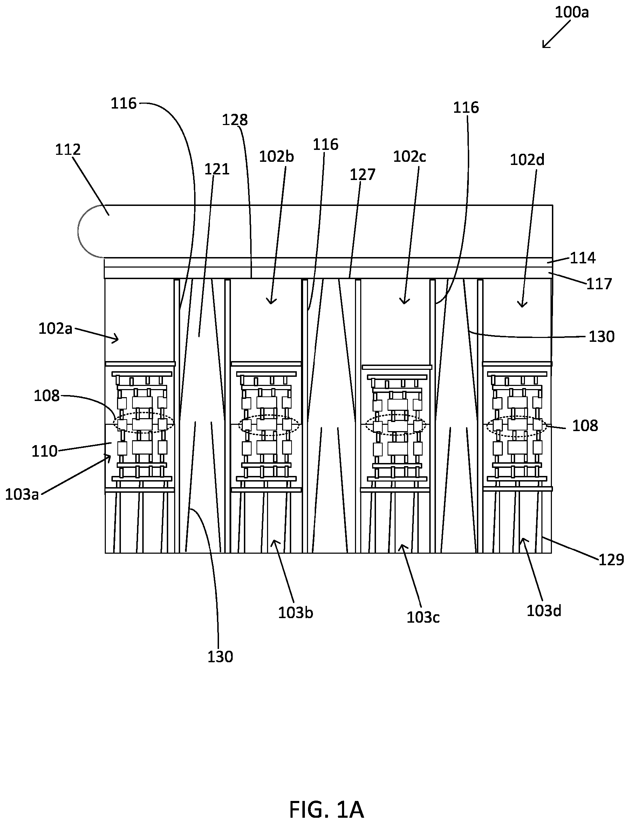

FIGS. 1A-1B illustrate embodiments of utilizing a hermetic capping layer on top of gap-fill oxide to eliminate lid attach bond voids. The package structures may be formed utilizing standard IC processing techniques. The methods of fabrication described herein create improved device performance in advanced 2.5D and 3D packaging.

FIG. 1A is a cross-sectional view of a portion of a package structure 100a comprising a hermetic compressive capping layer for lid attach with a gap-fill oxide. In an embodiment, the package structure 100a may comprise one or more top dies 102a-102d, wherein the top dies comprise a back side comprising silicon and an active side comprising passive and active devices in an embodiment. The backsides of the top dies 102a-102d do not have such active circuitry. The active sides comprise dielectric material(s) with conductive traces interspersed therein. In an embodiment, top dies 102a-102d may comprise chiplets. In an embodiment, the top dies 102a-102d may include processor circuitry, memory circuitry, control circuitry, signal and power routing circuitry, and so on.

Both bottom dies 103a-103d (wherein bottom dies may comprise single bottom dies or may comprise collective bottom dies in some embodiments) and top dies 102a-102d may include any suitable substrates and device components inclusive of semiconductor dies having active sides with metallization layers fabricated using known semiconductor manufacturing processes. The active sides of both the top dies 102a-102d and the base/bottom dies 103a-103d may include any suitable devices such as transistors, capacitors, resistors, etc. As shown, in some embodiments, top surfaces 128 of the top dies 102a-102d are substantially coplanar.

In an embodiment, a hybrid bond 108 couples the active sides of the top dies 102a-102d to active sides of corresponding bottom dies 103a-103d (or a single bottom die), wherein the bottom dies 103a-103d comprise a silicon backside and an active front side. Hybrid bonding indicates bonding between surfaces that each include metallization (e.g., metal pads) interspersed with a die dielectric material 110. Bonds are formed between corresponding metallization and between corresponding dielectric material to form a wafer to wafer bond, die to wafer bond, or die to die bond, depending upon the process. Such hybrid bonds may be performed using any techniques known in the art. In some embodiments, hybrid bonds 108 include die-to-die interconnects with sub 10 micrometer pitch, such that FIG. 1A may have dimensions which are not to scale with the figure when compared to those obtained from scanning electron microscope (SEM) or transmission electron microscope (TEM) images, in an embodiment.

The hybrid bonds 108 may be surrounded by the die dielectric material 110. In an embodiment, the die dielectric material 110 may comprise an inorganic dielectric material not having carbon to hydrogen bonds and being characterized as an electrical insulator. For example, an inorganic dielectric material may have a resistivity comparable to that of silicon dioxide. In other embodiments, while carbon may not be a foundational component of the die dielectric material 110 it may include carbon as, for example, as a dopant.

Through silicon vias (TSVs) 129 may couple the bottom dies 103a-103d to a substrate, such as flip chip ball grid array (FC-BGA) substrate or to a printed circuit board (PCB) directly (FC-BGA, PCB not shown). TSVs 129 may comprise a conductive material and may extend through the silicon backside of the bottom dies 103a-103d and may conductively couple with metallization within the active region of the bottom dies 103a-103d.

A liner material 116 is on sidewalls of the top dies 102a-102d and on sidewall of the bottom dies 103a-103d. The liner material 116 may comprise a silicon nitride material in an embodiment, or a SiNx material in other embodiments, wherein the amount of nitrogen in the liner material may be varied. In other embodiments, the liner may comprise metal or metal alloys. In an embodiment, a thickness of the liner material 116 may be between about 200 nm and 500 nm, and the liner material 116 may comprise a PECVD liner material or may be formed utilizing any other suitably liner material 116 formation process such as physical vapor deposition (PVD) or chemical vapor deposition (CVD), for example. In an embodiment, the liner material 116 may comprise a compressive stress and may comprise a hermetic liner.

A fill material 121 is on the liner material 116. The fill material 121 is between adjacent top dies 102a-102d and may be on sidewalls of the bottom dies 103a-103d. The fill material 121 may comprise an oxide material, such as a silicon dioxide material in an embodiment. The fill material 121 may comprise a plasma enhanced vapor deposition (PECVD) oxide material in an embodiment. The fill material 121 may be directly on the liner material 116 and may comprise a lateral width of between about 20 microns to about 20 mm in an embodiment. The fill material 121 may comprise a depth of between 10 um and 50 um in an embodiment and may comprise a densified oxide material. The fill material 121 may comprise one or more seams 130 (a seam is the interface between the bottom-up grown and sidewall grown oxide during PECVD deposition process and it is visible in XSEM images with proper focusing).

A capping layer 117 may be on a surface 127 of the fill material 121 and on the surfaces 128 of the top dies 102a-102d. The capping layer 117 may comprise a hermetic compressive SiNx film and may comprise a thickness between 1 micron and 2 microns, in an embodiment. The capping layer 117 may comprise the same material as the liner material 116 in an embodiment. In other embodiments, the liner material 116 and the capping layer material 117 may comprise different materials or may comprise different percentage compositions of silicon and nitrogen. In an embodiment, the capping layer 117 may or may not comprise a similar compressive stress range as the liner material 116. In an embodiment, the capping layer 117 may comprise a thickness that is two or more times greater than that of the liner material 116. The capping layer 117 provides a hermetic layer that can suppress outgassing and shrinkage of the fill material 121. Based on the surface topography and wafer bow during processing, the capping layer 117 thickness can be optimized to prevent fill material voids between top dies 102a-102d, and to optimize the wafer surface topographical profile. It is important to note that, based on the topography and wafer bow, other hermetic dielectric or metal layers can be used as capping layer.

A lid 112 is on a surface of the capping layer 117, wherein a surface of the lid 112 comprises a lid oxide liner 114. The lid oxide liner 114 of the lid 112 is in direct contact with the capping layer 117 and may comprise a silicon dioxide material. In an embodiment, the lid oxide liner 114 may comprise a thickness of between about 100 to 200 nanometers. The lid 112 may comprise a TMS thermal mechanical silicon (TMS) lid in an embodiment and may be fusion bonded to the capping layer 117. The lid 112 may comprise a conductive material and may further comprise a thermal interface material (not shown) between the top dies 102a-102d and the lid 112. The thermal interface material facilitates heat flow between the die 102 and the lid 112. A heat sink (not shown) may be mounted on an upper surface of the lid 112 to receive and disperse heat from the lid 112. In an embodiment, the hermetic capping layer 117 on top of the fill material 121 eliminates lid 112 attach bond voids. The use of the single hermetic capping layer 117 provides a higher temperature lid 112 attach process by suppressing fill material 121 shrinkage and outgassing and can compensates for tensile bow to optimize the flatness of the wafer during processing. In some cases, an integrated heat spreader (IHS) may be on top of the TMS lid 112, which may be coupled to the lid 112 with a thermal interface material 1 (TIM 1) that may be further coupled to a heat sink via a thermal interface material 2 (TIM 2), as is known in the art.

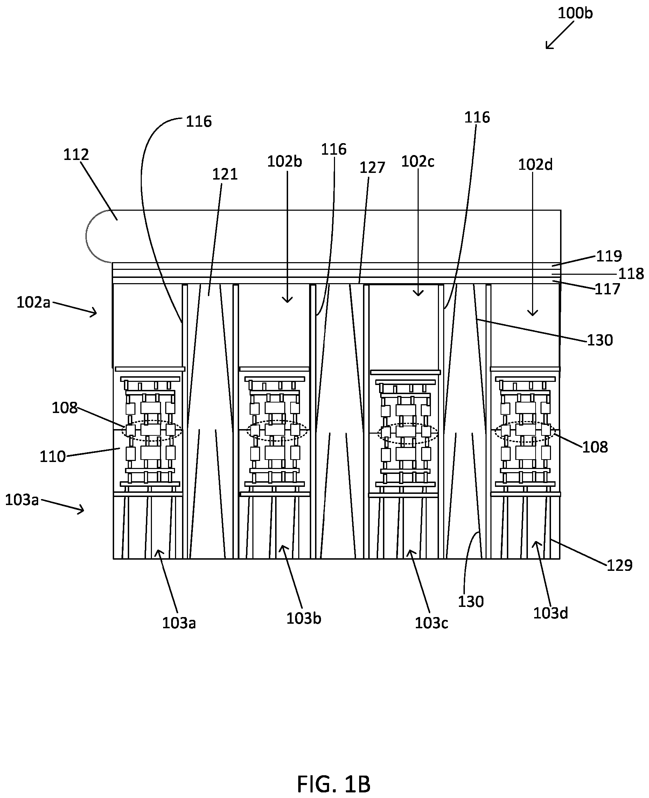

FIG. 1B is a cross-sectional view of a portion of a package structure 100b comprising two capping layers, wherein a hermetic first capping layer 117 and an oxide layer 118, which may comprise a PECVD Oxide second capping layer 118 in an embodiment, are stacked on each other. In an embodiment, the use of the two capping layers 117, 118 enables optimization of a surface profile over a large topography. In another embodiment, where a bow compensation is not needed, the thicknesses of the first capping layer 117 may be less than a thickness of the second capping layer 118. In an embodiment, the first capping layer 117 may comprise a thickness of 500 nm or less and a thickness of the second capping layer 118 may comprise a thickness of 1 micron or greater.

In an embodiment, the package structure 101b may comprise one or more top dies 102a-102d hybrid bonded with hybrid bonds 108 to bottom dies 103a-103d. TSVs 129 may couple the bottom dies 103a-103d to a substrate, such as a PCB (not shown). A liner material 116 is on sidewalls of the top dies 102a-102d and on sidewalls of the bottom dies 103a-103d. The liner material 116 may comprise a silicon nitride material in an embodiment, or a SiNx material in other embodiments, wherein the amount of nitrogen in the liner material may be varied. In an embodiment, the thickness of the liner material 116 may be between about 200 nm and 500nm, and the liner material 116 may comprise a PECVD liner material 116. In an embodiment, the liner material 116 may comprise a compressive stress and may comprise a hermetic liner.

A fill material 121 is on the liner material 116 and is between adjacent top dies 102a-102d and may be on sidewalls of the bottom dies 103a-103d. The fill material 121 may comprise an oxide material, such as a silicon dioxide material in an embodiment. The fill material 121 may comprise a plasma enhanced vapor deposition (PECVD) oxide material in an embodiment. The fill material 121 may be directly on the liner 116 and may comprise a lateral width of between about 20 microns to about 20 mm in an embodiment. The fill material 121 may comprise a densified oxide material. The fill material 121 may comprise one or more seams 130.

A first capping layer 117 may be on a surface 127 of the fill material 121. The first capping layer 117 may comprise a hermetic compressive SiNx film capping layer 117 and may comprise a thickness between 1-2 microns. In other embodiments, the liner material 116 and the first capping layer material 117 may comprise different materials or may comprise different percentage compositions of silicon and nitrogen and may or may not comprise a similar compressive stress range. In some embodiments the first capping layer 117 may comprise the same material as the liner 116. In an embodiment, the first capping layer 117 may comprise a thickness that is two or more times greater than that of the liner 116. The capping layer 117 provides a hermetic layer that can suppress fill material outgassing and shrinkage. Based on the surface topography and wafer bow during processing, the capping layer 117 thickness can be optimized to prevent fill material 121 voids between top dies 102a-102d.

A second capping layer 118 may be on a surface of the first capping layer 117. The second capping layer 118 may comprise a silicon oxide capping layer 118 and may comprise a thickness between 1-2 microns. The second capping layer 118 may comprise a thickness that is the same as the first capping layer 117 or in some embodiments may comprise a thickness which is less than the first capping layer 117. In other embodiments, the second capping layer 118 may comprise a thickness that is greater than a thickness of the first capping layer 117. The capping layers 117, 118 provide a hermetic layer that can suppress fill material outgassing and shrinkage. Based on the surface topography and wafer bow during processing, the first and second capping layers 117, 118 thicknesses can be optimized to prevent fill material voids between top dies 102.

A lid 112 is on a surface of the second capping layer 118, wherein a surface of the lid 112 comprises a lid nitride liner 119. The lid nitride liner 119 is in direct contact with the second capping layer 118. The lid 112 may comprise a TMS silicon lid in an embodiment, and the lid nitride layer 119 may be fusion bonded to the capping layer 118.

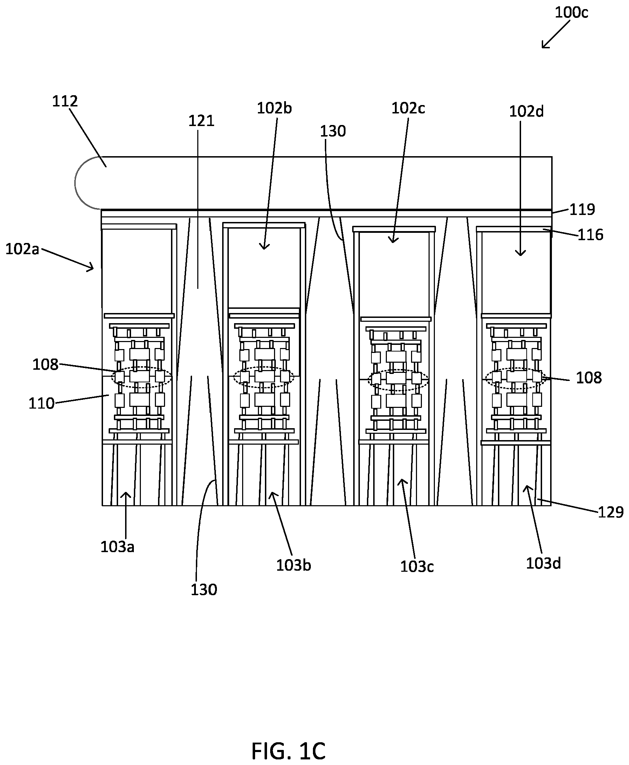

FIG. 1C depicts an embodiment of a cross-sectional view of a portion of a package structure 101c comprising a fill material 121 directly in contact with a lid nitride layer 119. In an embodiment, the package structure 101c may comprise one or more top dies 102a-102d, hybrid bonded by hybrid bonds 108 to bottom dies 103a-103d. TSVs 129 may couple the bottom dies 103a-103d to a substrate, such as FC-BGA or directly to a PCB (not shown). A liner material 116 is on sidewalls of the top dies 102 and on sidewalls of the bottom dies 103a-103d. The liner material 116 may comprise a silicon nitride material in an embodiment, or a SiNx material in other embodiments, wherein the amount of nitrogen in the liner material may be varied. In an embodiment, the liner material 116 may comprise a PECVD liner material and may comprise a compressive stress.

A fill material 121 is on the liner material 116 and is between adjacent top dies 102a-102d and may be on sidewalls of the top dies 102a-102d and on sidewalls of bottom dies 103a-103d. The fill material 121 may comprise an oxide material, such as a silicon dioxide material in an embodiment. The fill material 121 may comprise a PECVD oxide material in an embodiment. The fill material 121 may comprise a lateral width of between about 20 microns to about 20 mm in an embodiment. The fill material 121 may comprise a relatively thermally stable oxide and may be directly attached to a lid 112. A pre-bond annealing step can be eliminated and lid 112 bonding temperatures can be minimized.

The lid 112 is on a surface of the fill material 121, wherein a surface of the lid 112 comprises a lid nitride liner 119. The lid nitride liner 119 is in direct contact with the fill material 121. The lid 112 may comprise a TMS silicon lid in an embodiment, and the lid nitride liner 119 may be fusion bonded to the fill material 121. The lid nitride liner 119 on top of the fill material 121 eliminates lid 112 attach bond voids. In an embodiment, the fill material seam 130 is continuous and is in direct contact with the lid nitride liner 119.

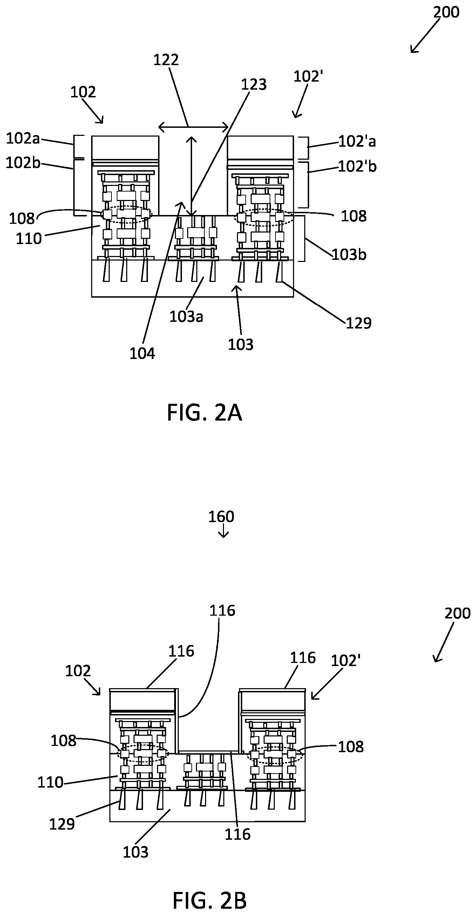

FIGS. 2A-2H depict methods of forming package structures comprising a hermetic compressive capping layer for lid attach with a gap-fill oxide. FIG. 2A depicts a cross-sectional view of a hybrid package structure 200 comprising a first die and second die 102, 102'. The first and second dies 102, 102' are adjacent to each other and separated by a distance 122. In an embodiment, the first and second dies 102, 102' may comprise an active circuitry device (i.e., circuitry that is to provide computational functionality when in operation). For example, the die 102, 102' may comprise circuitry to perform a defined subset of functionality such as a memory chip, a microprocessor, a microcontroller, and/or a commodity IC (e.g., chip used for repetitive processing routines, simple tasks, application specific IC, etc.). In an embodiment, the dies 102, 102' may comprise a chiplet. A trench 104, may comprise a depth 123, which may comprise from about 10 microns to about 50 microns.

The top dies 102, 102' comprise a backside 102a, 102a' and an active side 102b, 102b'. The backsides 102a, 102a' may comprise a silicon backside, while the active sides 102b, 102b' comprise circuitry such as transistors and passive devices for example. A bottom die 103 comprises a silicon backside 103a and an active side 103b within the die dielectric material 110.

The bottom die 103 may be below the first and second dies 102a, 102'. The bottom die 103 may comprise an active circuitry device and may be coupled to the first and second dies 102, 102 by a hybrid bond 108, which is between active sides 102b of the first and second dies 102, 102' and the active side 103b of the bottom die 103. The hybrid bond 108 is within a die dielectric 110. In an embodiment, the first, second and bottom dies 102, 102', 103 may comprise a portion of a multichip composite device 200. TSVs 129 are embedded in Si and will be revealed at later stage (not shown in the process flow) to couple the dies 102, 102', 103 to a package substrate (not shown)

FIG. 2B depicts a cross-sectional view of the hybrid package structure 200 wherein a process 160 is utilized to form a liner 116 on top sides and sidewalls of the first and second dies 102, 102' and on a top side of the bottom die 103. The liner 116 may comprise silicon and nitrogen and may comprise a silicon nitride material. In another embodiment, the liner 116 may comprise a silicon oxynitride material. The liner 116 may comprise a thickness of 200 nm to 500 nm. In an embodiment, the liner 116 may comprise a single hermetic compressive SiNx film, wherein the compressive layer may comprise a stress of between about 200 MPa to about 600 MPa.

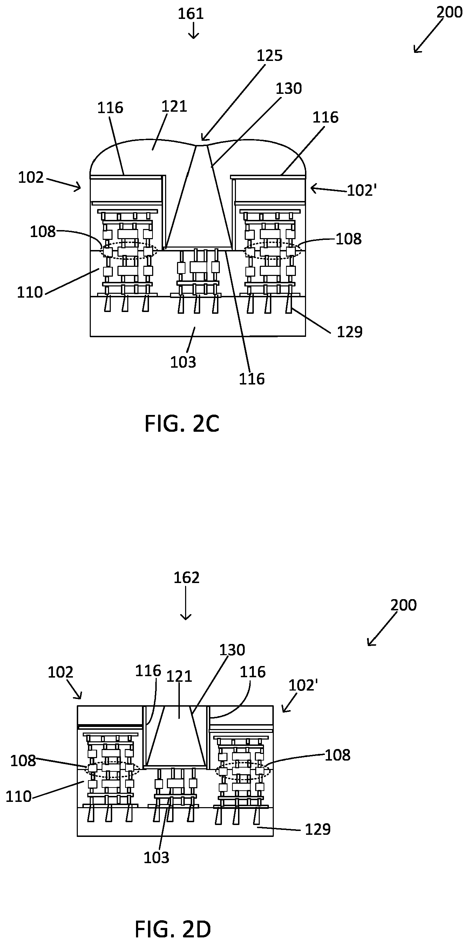

FIG. 2C depicts a cross-sectional view of the hybrid package structure 200 wherein a fill material 121 is formed within the trench utilizing a fill process 161. In an embodiment, the fill material 121 comprises a silicon dioxide material, such as a plasma enhanced chemical vapor deposition (PECVD) silicon dioxide material and fills in the distance between the first and second dies 102, 102'. In an embodiment, the fill material 121 may have a surface dip 125 on a surface of the fill material 121 and a seam 130 from a bottom corner of the trench to a top surface of the fill material 121. The seam 130 is continuous in an embodiment. In an embodiment, the fill material 121 surface may optionally undergo an outgassing process, wherein gas may be removed from the fill material 121 under a particular temperature and time regime, according to the particular application.

FIG. 2D depicts a cross-sectional view of the hybrid package structure 200 wherein a planarization process 162 is employed wherein the fill material 121 is planarized. In an embodiment, the liner 116 on the silicon backside surfaces of the top dies 102, 102' may be removed by employing a grinding and/or a polishing process, such as a chemical mechanical polishing (CMP) process. In an embodiment, the liner 116 is removed from the backside of the top dies 102, 102'.

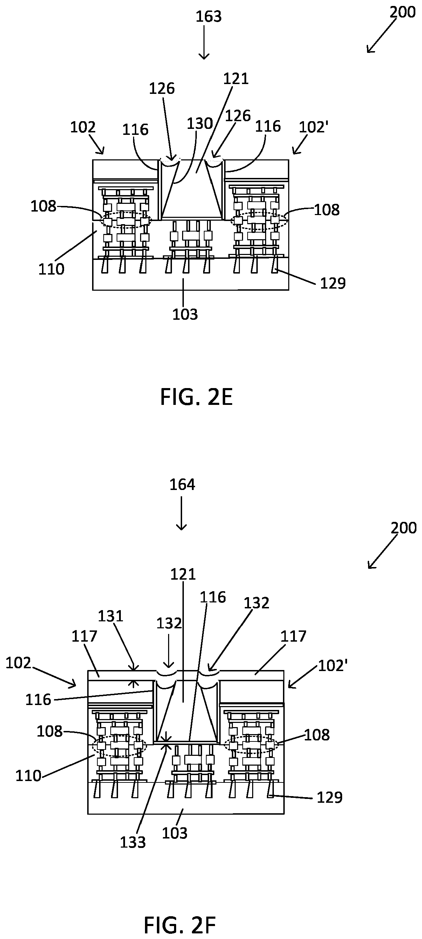

FIG. 2E depicts an optional densification process 163 of the fill material 121, wherein the fill material 121 may exhibit additional surface dips 126. Portions of the seams 130 are on the surface of the fill material 121. In an embodiment, the densification process 163 can be omitted and the dips 126 may not be visible. FIG. 2F depicts a cross-sectional view of the hybrid package structure subsequent to a formation process 164 wherein a capping layer 117 may be formed on the surface of the fill material 121 and on the surfaces of the top dies 102, 102'. The capping layer 117 on the surface of the fill material 121 may comprise a thickness 131 that is two or more times greater than that of the liner 116 on the top die 102, 102' sidewalls and on the surface of the third die 103 in an embodiment.

The capping layer 117 on the surface of the fill material 121 may comprise surface dips 132 in an embodiment. In an embodiment, the capping layer 117 on the surface of the fill material 121 may comprise a hermetic silicon nitride capping layer. In an embodiment, the capping layer 117 may comprise a compressive stress. In an embodiment, based on the surface topography and the wafer bow, the capping layer 117 thickness 131 can be optimized to reduce wafer bow. In an embodiment, the highly compressive hermetic liner 116 can compensate for some of the tensile wafer bow during processing to optimize a subsequent lid attach processing.

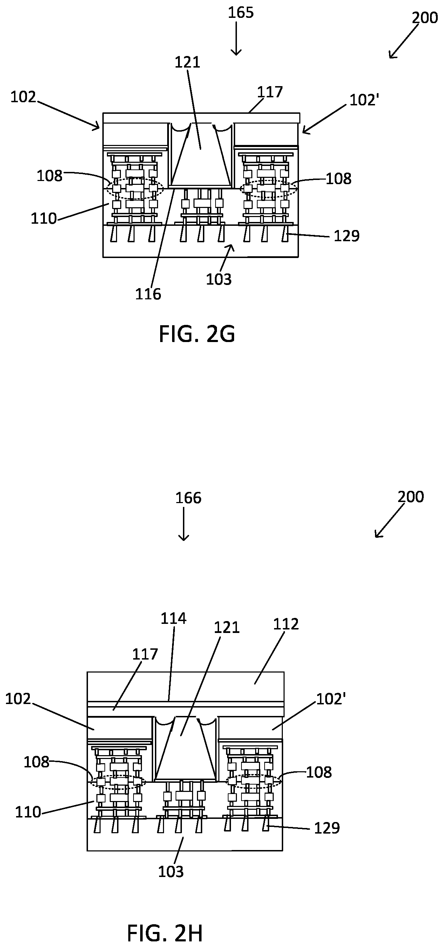

FIG. 2G depicts a planarization process 165 wherein the capping layer 117 is planarized. After planarization (to optimize topography and/or to reduce roughness), a lid 112 may be bonded at higher temperature and the hermetic capping layer 117 will suppress fill material 121 outgassing and shrinkage.

FIG. 2H depicts a lid attach process 166 wherein a lid 112 is attached to the surface of the capping layer 117. The lid 112 may comprise a TMS silicon lid with a silicon dioxide coating in an embodiment. The lid 112 comprises a lid oxide liner 114 on its surface and may be bonded to the capping layer 117 by fusion bonding in an embodiment. The lid oxide liner 114 comprise a thickness of about 200 nm to about 500 nm in an embodiment. Optionally, a pre-bonding anneal may be performed prior to the lid 112 attach process 166. The lid 112 can be bonded at a higher temperature since the hermetic capping layer will suppress fill material 121 outgassing and/or shrinkage.

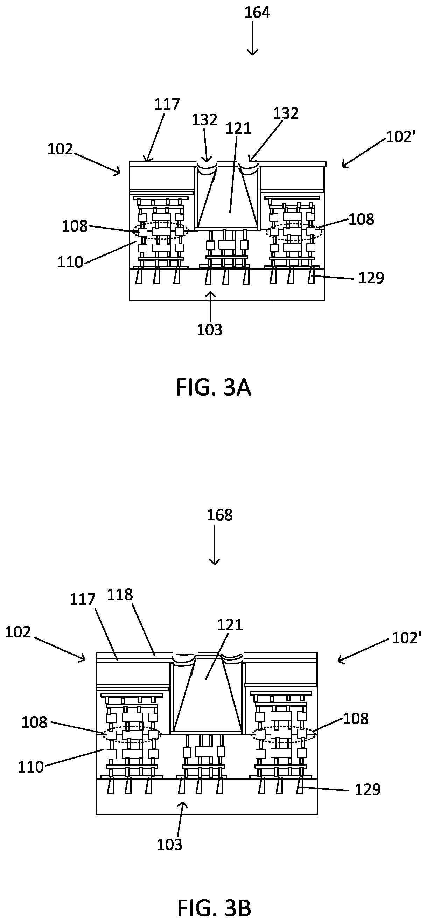

FIGS. 3A-3D depict methods of forming package structures comprising a hermetic compressive capping layer for lid attach with a gap-fill oxide wherein the lid comprises a nitride film coating. FIGS. 3A-3B depict cross-sectional views of a formation process 164 wherein two capping layers 117, 118 may be formed on the surface of the fill material 121 and over the surfaces of the top dies 102, 102'. In FIG. 3A, top dies 102, 102' are hybrid bonded 108 to bottom die 103. A first capping layer 117 is formed using process 164 on the surface of the fill material 121 and may comprise a thickness that is close to or greater than a thickness of the liner material 116 that is on the sidewalls of the top dies 102, 102' and on the surface of the third die 103, in an embodiment. There may be dips 132 on the surface of the first capping layer 117.

FIG. 3B depicts a second capping layer 118 formation process 168 wherein a silicon oxide material, or any suitable oxide material, may be formed on the first capping layer 117. In an embodiment, the first and second capping layers 117, 118 may be formed in the same process step. In an embodiment, the first capping layer 117 may comprise a hermetic silicon nitride capping layer 117. The second capping layer 118 may comprise a dielectric layer, such as a silicon dioxide layer for example on the first capping layer 117. The first capping layer 117 may comprise a thickness of about 1 nm to about 200 nm an embodiment, and the second capping layer 118 may comprise a thickness of about 1-2 microns in an embodiment. In an embodiment, a combined thickness of both the first and second capping layers 117, 118 before planarization is from about 2 microns to about 4 microns.

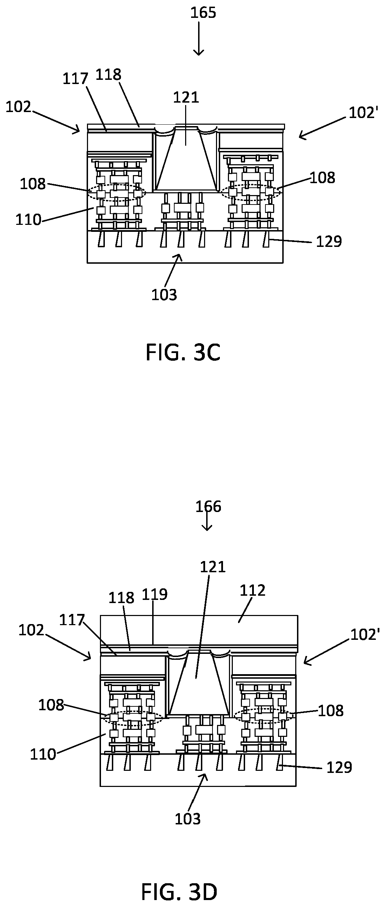

FIG. 3C depicts a planarizing process 165 wherein the capping layers 117, 118 are planarized. FIG. 3D depicts a lid attach process 166 wherein a lid 112 is attached to the surface of the second capping layer 118. The lid 112 may comprise a TMS silicon lid with a lid nitride liner 119 in an embodiment. The lid 112 nitride liner 119 may be bonded to the second capping layer 118 by fusion bonding in an embodiment. The lid nitride layer 119 comprises a thickness of about 100 nm to about 500 nm in an embodiment. Optionally, a pre-bonding anneal may be performed prior to lid 112 attach. The lid 112 can be bonded at a higher temperature since the hermetic capping layer 117 will suppress fill material 121 outgassing and/or shrinkage. Based on the surface topography and wafer bow, thicknesses of the capping layers 117, 118 may be optimized according to the particular design requirements.

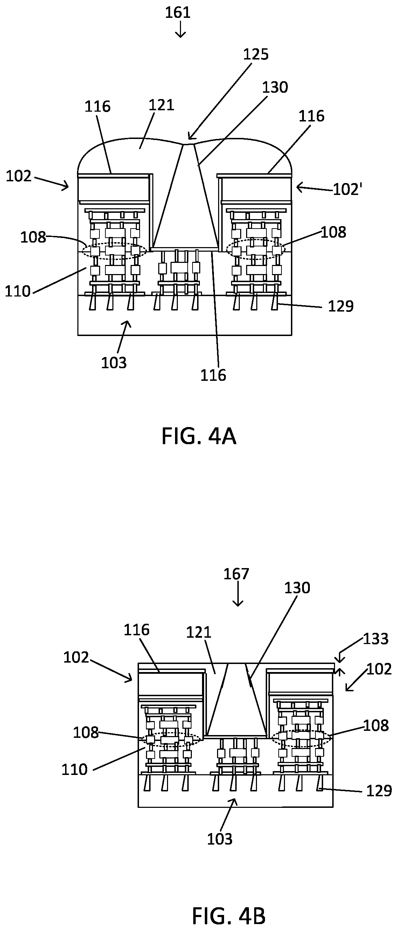

FIGS. 4A-4C depict methods of forming package structures comprising a lid attach process with a high quality gap-fill oxide, such as depicted in FIG. 1C, for example. FIG. 4A depicts a cross-sectional view of the hybrid package structure wherein a fill material 121 is formed within the trench utilizing a fill process 161. In an embodiment, the fill material 121 comprises a silicon dioxide material, such as a plasma enhanced chemical vapor deposition (PECVD) silicon dioxide material and fills in the distance between the first and second dies 102, 102'. In an embodiment, the fill material 121 may have a surface dip 125 on a surface of the fill material 121 and a seam 130 extending from a bottom corner of the trench to a top surface of the fill material 121. The seam 130 is continuous in an embodiment. In an embodiment, the fill material 121 surface may optionally undergo an outgassing process, wherein gas may be removed from the fill material 121 under a particular temperature and time regime, according to the particular application.

FIG. 4B depicts a cross-sectional view of the hybrid package structure wherein a planarization process 167 is utilized by employing a grinding and/or a polishing process, such as a chemical mechanical polishing (CMP) process wherein the fill material 121 is planarized. In an embodiment, a portion 133 of the fill material 121 remains over the silicon backside surfaces of the top dies 102, 102' and directly on the liner material 116. In an embodiment, a thickness of the portion 133 of the fill material 121 remaining on the top surfaces of the top dies 102, 102' may comprise between about 1 micron to about 2 microns in an embodiment. The fill material 121 may act as the bonding layer with a lid 112. The fill material 121 comprises a high quality dielectric material with a high thermal stability. A pre-bond anneal can be eliminated and a lid bonding temperature can be optimized to produce a void free lid attach.

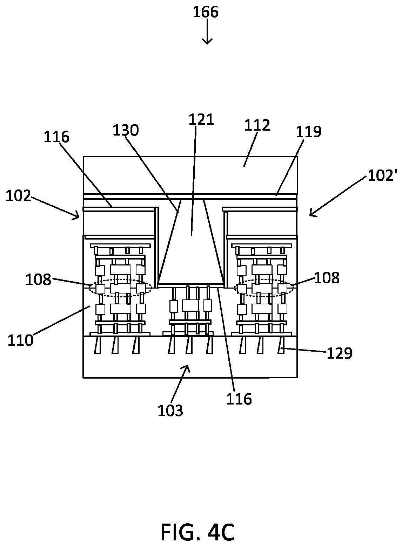

FIG. 4C depicts a lid attach process 166 wherein a lid 112 is attached to the surface of the fill material 121. The lid 112 may comprise a TMS silicon lid with a silicon dioxide coating in an embodiment. The lid 112 comprises a lid nitride 119 on its surface which is bonded to the fill material 121 by fusion bonding in an embodiment. The lid nitride 119 comprise a thickness of about 200 nm to about 500 nm in an embodiment.

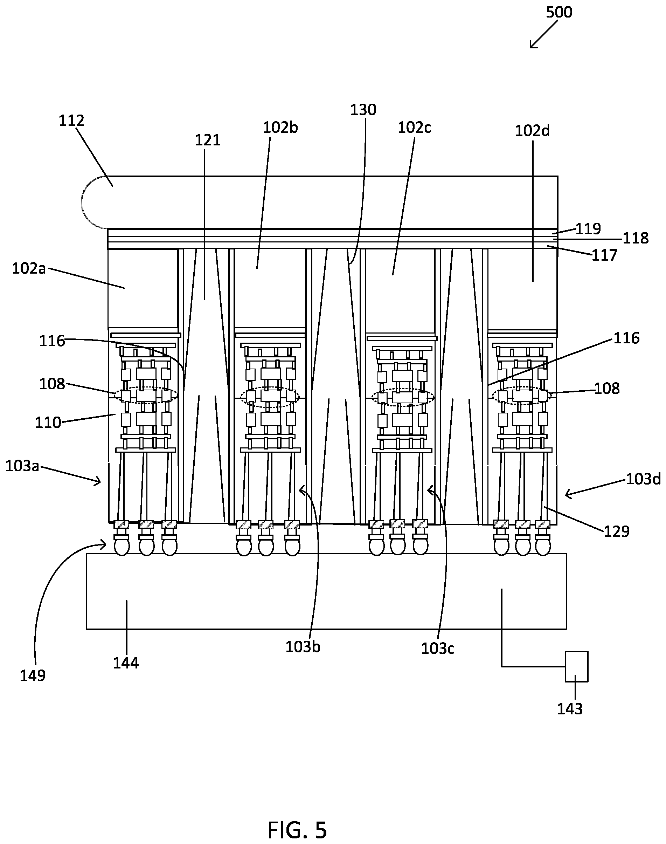

FIG. 5 depicts an IC package structure 500, such as a package structure including two capping layers on a fill dielectric material according to embodiments herein. The package structure 500 may be similar to the package structure depicted in FIG. 1B, for example. Two capping layers are utilized wherein a hermetic SiNx capping layer 117 and a PECVD Oxide capping layer 118 are stacked upon each other. In an embodiment, the package structure 500 may comprise a plurality of top dies 102a-102d, wherein the top dies 102a-102d comprise a back side comprising silicon and an active side comprising passive and active devices in an embodiment. The active sides comprise die dielectric material(s) 110 with conductive traces interspersed therein. In an embodiment, top dies 102a-102d may comprise chiplets. A plurality of bottom or base dies 103a-103d are each individually hybrid bonded to corresponding top dies 102a-102d. The hybrid bonds 108 are between the active areas of the top dies 102a-102d and the bottom dies 103a-103d.

Through silicon vias (TSVs) 129 may couple the bottom dies 103a-103d to a package substrate 144, such as a FC-BGA substrate or directly to a printed circuit board (PCB), wherein the TSVs are conductively coupled with metallization within the active regions of the bottom dies 103a-103d. A liner material 116 is on sidewalls of the top dies 102a-102d and on sidewalls of the bottom dies 103a-103d. The liner material 116 may comprise a silicon nitride material in an embodiment, or a SiNx material in other embodiments, wherein the amount of nitrogen in the liner material may be varied. In an embodiment, the thickness of the liner material 116 may be between about 200 to 500 nm wherein the liner material 116 may comprise a PECVD liner material.

A fill material 121 is on the liner material 116 and is between adjacent top dies 102a-102d and is on sidewalls of the top dies 102a-102d and on sidewalls of the bottom dies 103a-103d. The fill material 121 may comprise an oxide material, such as a silicon dioxide material in an embodiment. The fill material 121 may comprise a plasma enhanced vapor deposition (PECVD) oxide material and may comprise a lateral width of between about 20 microns to about 20 mm in an embodiment. The fill material 121 may comprise a depth of between 10 microns and 50 microns in an embodiment and may comprise a densified oxide material in an embodiment.

A first capping layer 117 may be on a surface of the fill material 121. The first capping layer 117 may comprise a hermetic compressive SiNx film, and may comprise a thickness between about 1 micron to about 200 microns. In an embodiment, the first capping layer 117 may comprise a thickness that is about equal to or greater than the thickness of the liner 116. The capping layer 117 provides a hermetic layer that can suppress fill material outgassing and shrinkage. A second capping layer 118 may be on a surface of the first capping layer 117. The second capping layer 118 may comprise a silicon oxide capping layer 118, and may comprise a thickness between 1 micron to 2 microns. The second capping layer 118 may comprise a thickness that is the same as the first capping layer 117 or in some embodiments may comprise a thickness which is less than the first capping layer 117. In other embodiments, the second capping layer 118 may comprise a thickness that is greater than a thickness of the first capping layer 117.

A lid 112 is on a surface of the second capping layer 118, wherein a surface of the lid 112 comprises a lid nitride coating 119. The lid nitride coating 119 is in direct contact with the second capping layer 118. The lid 112 may comprise a TMS silicon lid in an embodiment, and the lid nitride layer 119 may be fusion bonded to the capping layer 118. The lid 112 may comprise a conductive material and may further comprise a thermal interface material between the die 102a-102d and the lid 112 in an embodiment. A heat sink (not shown) may be mounted on an upper surface of the lid 112 to receive and disperse heat from the lid 112. In an embodiment, the hermetic capping layer 117 on top of the fill material 121 eliminates lid 112 attach bond voids. In some cases (not shown), on top of the TMS lid 112, an IHS (integrated heat spreader) lid may be coupled with a thermal interface material 1 (TIM 1) that may be further coupled to a heat sink via a thermal interface material 2 (TIM 2), as is known in the art.

In some embodiments, the dies 102a-102d may comprise chiplet structures which may comprise components of a system on a chip (SOC) structure. In an embodiment, the multichip package structure/device 500 may comprise any number of die/devices 102a-102n that may be coupled to bottom die/devices 103a-103n. The dies 102a-102d, 103a-103d as shown in FIG. 5 may be coupled to a package substrate or directly to the board 144, such as a printed circuit board, in an embodiment through solder structures 149 that are coupled to TSV structures 129 in an embodiment. A power supply 143, which may comprise any suitable power supply as known in the art, may be coupled to dies 102, 103 by the board 144, in an embodiment.

Discussion now turns to operations for assembling and/or fabricating the discussed structures.

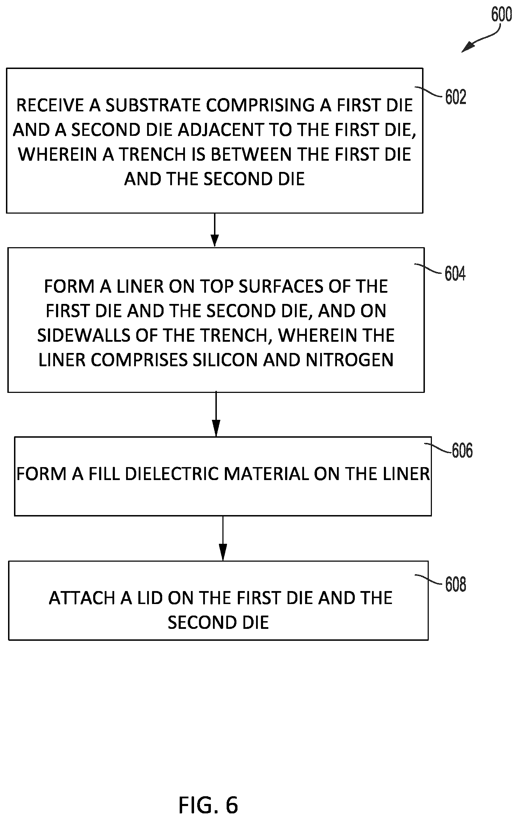

FIG. 6 is a flow chart of a process 600 of fabricating package structures, such as a multichip package structure comprising a hermetic compressive capping layer for successful lid attach with gap-fill oxide. For example, process 600 may be used to fabricate any of the microelectronic multichip package structures of FIGS. 1A-1C for example.

As set forth in block 602, a substrate may be received comprising a first die on the substrate and a second die on the substrate, adjacent to the first die, wherein a trench is between the first die and the second die. In an embodiment, the first die and the second die may comprise top dies which may be hybrid bonded to a base die (or individual bottom dies) below the first and second dies, wherein a sidewall or a top surface of the bottom die is adjacent to the trench. In an embodiment, top dies bonded to the base, or bottom die(s) may comprise a portion of a multichip device or a 3D stacked device. The multichip device may include one or more IC dies or chiplets bonded to a region of a surface of the base die. The dies may comprise a central processing unit (CPU) or a field programmable gate array (FPGA) die, for example or may comprise any suitable logic die for the particular application.

In an embodiment, the one or more top dies or chiplets may be bonded to the surface of the base die using hybrid bonding. Hybrid bonding may comprise bonding between surfaces that each include metallization (e.g., metal pads) interspersed within dielectric material. Bonds are formed between corresponding metallization and between corresponding dielectric material between top dies and bottom dies to form a wafer to wafer bond, a die to wafer bond, or a die to die bond. Such hybrid bonds may be performed using any techniques known in the art. In some embodiments, hybrid bonds include die-to-die interconnects with sub 10 micrometer pitch. In an embodiment, the first and second dies may be reconstituted on a carrier wafer.

A distance (die to die spacing) is between the first and second dies. The distance between the dies may range from about 10 microns to about 20 microns in an embodiment. In other embodiments, the distance may comprise up to about 50 mm. A trench is between the first and second dies. The trench may comprise an opening between the first and second dies, which will be subsequently filled with a dielectric material, such as a silicon dioxide material, for example. In an embodiment, the trench comprises a rectangular shape but may comprise any suitable geometry as required by the particular application. In an embodiment, the trench may comprise a depth of about 10 microns to about 50 microns and a lateral width of between about 20 microns to about 20 mm. The top and bottom dies comprise an active side and a silicon backside. The active areas of the first and second dies are hybrid bonded to the active areas of the bottom die/s. In an embodiment, the conductive traces which are dispersed within a die dielectric material of the active area of the first die are hybrid bonded to the active area of a first bottom die, and the conductive traces of the active area of the second die are hybrid bonded to the active area of an adjacent second bottom die. The die dielectric material comprises any suitable dielectric material such as silicon dioxide and the like. The die dielectric material is adjacent to the trench.

As set forth in block 604, a liner is formed on top surfaces of the first die and the second die, and on sidewalls of the trench, wherein the liner comprises silicon and nitrogen. In an embodiment, the liner may be formed using a PECVD process or any other suitable process such as a PVD or ALD process, for example. In an embodiment, the liner may comprise a silicon nitride layer and may comprise a thickness of about 200 nm to about 500 nm. In an embodiment, the liner may be formed on a surface and on sidewalls of the base die which may be at the bottom of the trench. In an embodiment, the liner may comprise a compressive SiNx film which is hermetic. In an embodiment, the liner may comprise a compressive stress which may comprise between about 200 MPa and 600 MPa.

At block 606, a fill dielectric material may be formed on the liner and may fill the trench. In an embodiment, the trench may be filled with the fill dielectric material by utilizing a plasma enhanced chemical vapor deposition (PECVD) Oxide process, in an embodiment, since the PECVD process has a higher a deposition rate than a PVD or an Atomic layer deposition (ALD) process, for example. The fill dielectric material formation process produces a superior oxide quality near the top die sidewalls and prevents shrinkage (and possible outgassing) at high temperature exposure. The quality of the fill material produces a gap fill material which prevents die to die spacing voids between the fill material and a lid.

In an embodiment, the fill material comprises an inorganic dielectric material and may comprise a silicon dioxide material. In an embodiment, the fill dielectric material may be formed on top of the die and may have a height as formed that is above a surface of the top dies. The height may then be ground and planarized such that a surface of the fill dielectric material may be coplanar with the surfaces of the top die surfaces. In other embodiments, 1-2 microns of the fill material may remain on the top surfaces of the first and second dies, wherein the fill material will act as the bonding layer with a lid. The fill dielectric material may comprise a high thermal stability.

In an embodiment, a pre-bond anneal may be avoided when the fill dielectric material is directly bonded to a lid. Optimization of the lid attach temperature may produce a void free lid attach.

In another embodiment, at least one capping layer may be formed directly on the fill material. In an embodiment a first capping layer may comprise a silicon nitride layer and may comprise a thickness of between 1 micron to 2 microns, but the thickness may be optimized for the particular application. In an embodiment, the first capping layer may comprise a PECVD hermetic capping layer and may comprise any composition SiNx according to the particular application. By utilizing a hermetic capping layer on top of the fill dielectric material lid attach bond voids in the fill dielectric material may be prevented.

In another embodiment, a second capping layer may be formed on the first capping layer. First capping layer may comprise a silicon nitride layer and may comprise a thickness of 1 nm to about 200 nm. The second capping layer may comprise a dielectric material such as a silicon dioxide material. A thickness of the second capping layer may be between 1 micron to 2 microns, but the thickness may be optimized for the particular application. In an embodiment, the second capping layer may comprise a PECVD second capping layer and may comprise any composition silicon, nitrogen and/or nitrogen according to the particular application. In an embodiment, the first capping layer and/or the second capping layer may be formed on the fill dielectric material.

As set forth in block 608, a TMS lid may be attached on the top surface of the first die and the second die. The lid attach process may comprise a temperature and time which may be optimized according to the particular application. The TMS lid may comprise any suitable lid and may comprise a thickness of about1 micron to about a full wafer thickness (~775 um). The lid may comprise a lid liner material, which may comprise either a silicon dioxide material and/or a silicon nitride material in some embodiments and may comprise a thickness of between 200 nanometers and 500 nanometers. In an embodiment, the lid liner material may be bonded directly with the fill dielectric material. In other embodiments, the lid liner may be attached to either one or two capping layers, wherein the one or more capping layer parameters and the lid attach temperature may be optimized to eliminate lid attach bond voids.

The embodiments herein provide a simplified process wherein a single capping layer, a double capping layer or no capping layer at all may be used to attach a TMS lid to a multichip package structure. Minimizing the number of interfaces between the dies and the lid results in a reduction in thermal contact resistance. Additionally, the total thickness (Z-height) of the multichip package can be minimized which improves thermal performance of the device structures therein. Because the hermetic capping layer materials are highly compressive, optimization of wafer profile topography is enabled while minimizing lid attach voids.

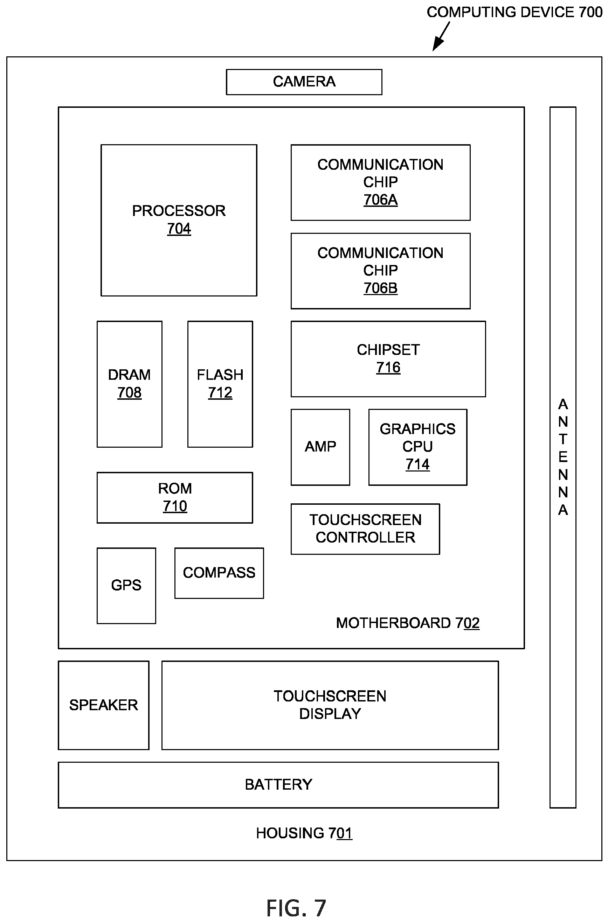

FIG. 7 illustrates an electronic or computing device 700 in accordance with one or more implementations of the present description. The computing device 700 may include a housing 701 having a board 702 disposed therein. The computing device 700 may include a number of integrated circuit components, including but not limited to a processor 704, at least one communication chip 706A, 706B, volatile memory 708 (e.g., DRAM), non-volatile memory 710 (e.g., ROM), flash memory 712, a graphics processor or CPU 714, a digital signal processor (not shown), a crypto processor (not shown), a chipset 716, an antenna, a display (touchscreen display), a touchscreen controller, a battery, an audio codec (not shown), a video codec (not shown), a power amplifier (AMP), a global positioning system (GPS) device, a compass, an accelerometer (not shown), a gyroscope (not shown), a speaker, a camera, and a mass storage device (not shown) (such as hard disk drive, compact disk (CD), digital versatile disk (DVD), and so forth). Any of the integrated circuit components may be physically and electrically coupled to the board 702. In some implementations, at least one of the integrated circuit components may be a part of the processor 704.

The communication chip enables wireless communications for the transfer of data to and from the computing device. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device may include a plurality of communication chips. For instance, a first communication chip may be dedicated to shorter range wireless communications such as Wi-Fi and Bluetooth and a second communication chip may be dedicated to longer range wireless communications such as GPS, EDGE, GPRS, CDMA, WiMAX, LTE, Ev-DO, and others.

The term "processor" may refer to any device or portion of a device that processes electronic data from registers and/or memory to transform that electronic data into other electronic data that may be stored in registers and/or memory. At least one of the integrated circuit components may include a multichip package structure comprising a hermetic compressive capping layer for successful lid attach with gap-fill oxide.

In various implementations, the computing device may be a laptop, a netbook, a notebook, an ultrabook, a smartphone, a tablet, a personal digital assistant (PDA), an ultramobile PC, a mobile phone, a desktop computer, a server, a printer, a scanner, a monitor, a settop box, an entertainment control unit, a digital camera, a portable music player, or a digital video recorder. In further implementations, the computing device may be any other electronic device that processes data.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure. It is understood that the subject matter of the present description is not necessarily limited to specific applications illustrated in FIGS. 1-7. The subject matter may be applied to other integrated circuit devices and assembly applications, as well as any appropriate electronic application, as will be understood to those skilled in the art.

The following examples pertain to further embodiments and specifics wherein the examples may be used anywhere in one or more embodiments, wherein a first example is an apparatus, comprising a first die on a first dielectric material and a second die on a second dielectric material, the first die adjacent to the second die. A third die below the first die, the third die hybrid bonded to the first die. A fourth die below the second die, the fourth die hybrid bonded to the second die; a layer comprising nitrogen and silicon, the layer directly on a top surface of the first die and directly on a top surface of the second die; a fill dielectric material between the first die and the second die; and a lid over the fill dielectric material.

In second examples, the first example further comprises wherein the layer comprises at least one of silicon nitride, a silicon oxynitride, a metal, or a metal alloy and wherein the layer has a thickness between 200 nm and 500 nm.

In third examples, wherein any one of examples 1-2 further comprise wherein the layer comprises a thickness between 1 micron to 2 microns and is on the fill material between the first die and the second die.

In fourth examples, wherein example 3 further comprises wherein the lid comprises a lid liner, the lid liner bonded to the layer, wherein the lid liner comprises a silicon dioxide layer.

In fifth examples, wherein example 3 further comprises the layer comprising a first capping layer, and wherein a second capping layer is on the first capping layer, wherein the second capping layer comprises a silicon dioxide layer.

In sixth examples, wherein example 5 further comprises wherein the lid comprises a lid liner, the lid liner bonded to the layer, wherein the lid liner comprises a silicon nitride layer.

In seventh examples, wherein example 5 further comprises wherein the second capping layer comprises a thickness of between 1 micron to 2 microns.

In eighth examples, wherein any of examples 1-7 further comprises wherein a distance between the first die and the second die is between 20 microns and 20 mm.

In ninth examples, wherein any of examples 1-8 further comprises wherein the lid comprises a lid liner, the lid liner bonded to the fill material, wherein the lid liner comprises a silicon nitride layer, and wherein the fill material extends 1micron to 2 microns above a surface of the first die and above a surface of the second die.

In tenth examples, wherein examples 9 further comprises a power supply coupled to the first die.

Example 11 is an apparatus, comprising a first die and a second die adjacent to the first die; a third die below the first die and hybrid bonded to the first die. A fourth die is below the second die and hybrid bonded to the second die. A fill dielectric material is between the first die and the second die, a capping layer on the fill dielectric material and on top surfaces of the first die and the second die, wherein the capping layer comprises silicon and nitrogen, and a lid over the first die, the second die, and the fill dielectric material.

In twelfth examples, wherein example 11 further comprises wherein the fill dielectric material comprises silicon and oxygen, and has a lateral width between 20 microns and 20 mm.

In thirteenth examples, wherein example 11 further comprises wherein a silicon nitride liner is on sidewalls of the first die and on sidewalls of the second die.

In fourteenth examples, wherein example further comprises wherein the silicon nitride liner comprises a thickness between 200 nm and 500 nm.

In fifteenth examples, wherein any of example 12-14 further comprises wherein the capping layer comprises a thickness of 1 micron to 2 microns and comprises one of a silicon oxide material or a silicon nitride material.

Example 16 is a method, comprising: receiving a substrate comprising a first die and a second die adjacent to the first die, wherein a trench is between the first die and the second die, and wherein a third die is below the first die and the second die, wherein the third die is hybrid bonded to the first die and hybrid bonded to the second die, forming a layer on top surfaces of the first die and the second die, wherein the layer comprises silicon and nitrogen, forming a fill dielectric material in the trench, and attaching a lid on the first die and the second die.

In seventeenth examples, wherein example 16 further comprises wherein the layer comprises a thickness between 200 nm and 500 nm and is on a top surface of the fill dielectric material, and wherein the lid comprises a silicon dioxide layer coating that is fusion bonded to the fill dielectric material.

In eighteenth examples, wherein any of example 16-17 further comprises wherein the layer comprises a thickness between 1 micron and 2 microns and is on a top surface of the fill dielectric material, and wherein the lid comprises a silicon dioxide layer coating that is fusion bonded to the layer.

In nineteenth examples, wherein example 18 further comprises further comprising forming an oxide layer on the layer, wherein the layer comprises a thickness between 1 micron to 2 microns, and wherein the oxide layer comprises a thickness between 1 micron to 2 microns, wherein the lid comprises a silicon nitride layer coating that is fusion bonded to the oxide layer.

In twentieth examples, wherein example 19 further comprises wherein a silicon nitride liner is on the sidewalls of the first die and on sidewalls of the second die.

It will be recognized that principles of the disclosure are not limited to the embodiments so described but can be practiced with modification and alteration without departing from the scope of the appended claims. The above embodiments may include the undertaking only a subset of such features, undertaking a different order of such features, undertaking a different combination of such features, and/or undertaking additional features than those features explicitly listed. The scope of the embodiments should, therefore, be determined with reference to the appended claims, along with the full scope of equivalents to which such claims are entitled.

The following section of the description relates to further examples. The numbered paragraphs in this section are not claims. The claims are set forth below in the later section headed "claims"
1. An apparatus, comprising: a first die on a first dielectric material and a second die on a second dielectric material, the first die adjacent to the second die; a third die below the first die, the third die hybrid bonded to the first die; a fourth die below the second die, the fourth die hybrid bonded to the second die; a layer comprising nitrogen and silicon, the layer directly on a top surface of the first die and directly on a top surface of the second die; a fill dielectric material between the first die and the second die; and a lid over the fill dielectric material.
2. The apparatus of clause 1, wherein the layer comprises at least one of silicon nitride, a silicon oxynitride, a metal, or a metal alloy and wherein the layer has a thickness between 200 nm and 500 nm.
3. The apparatus of clause 1, wherein the layer comprises a thickness between 1 micron to 2 microns and is on the fill dielectric material between the first die and the second die.
4. The apparatus of clause 3, wherein the lid comprises a lid liner, the lid liner bonded to the layer, wherein the lid liner comprises a silicon dioxide layer.
5. The apparatus of clause 3, wherein the layer comprises a first capping layer, and wherein a second capping layer is on the first capping layer, wherein the second capping layer comprises a silicon dioxide layer.
6. The apparatus of clause 5, wherein the lid comprises a lid liner, the lid liner bonded to the layer, wherein the lid liner comprises a silicon nitride layer.
7. The apparatus of clause 5, wherein the second capping layer comprises a thickness of between 1 micron to 2 microns.
8. The apparatus of clause 1, wherein a distance between the first die and the second die is between 20 microns and 20 mm.
9. The apparatus of clause 1, wherein the lid comprises a lid liner, the lid liner bonded to the fill dielectric material, wherein the lid liner comprises a silicon nitride layer, and wherein the fill dielectric material extends 1 micron to 2 microns above a surface of the first die and above a surface of the second die.
10. The apparatus of clause 1, further comprising a power supply coupled to the first die.
11. An apparatus, comprising: a first die and a second die adjacent to the first die; a third die below the first die and hybrid bonded to the first die; a fourth die below the second die and hybrid bonded to the second die; a fill dielectric material between the first die and the second die; a capping layer on the fill dielectric material and on top surfaces of the first die and the second die, wherein the capping layer comprises silicon and nitrogen; and a lid over the first die, the second die, and the fill dielectric material.
12. The apparatus of clause 11, wherein the fill dielectric material comprises silicon and oxygen, and has a lateral width between 20 microns and 20 mm.
13. The apparatus of clause 11, wherein a silicon nitride liner is on sidewalls of the first die and on sidewalls of the second die.
14. The apparatus of clause 13, wherein the silicon nitride liner comprises a thickness between 200 nm and 500 nm.
15. The apparatus of clause 11, wherein the capping layer comprises a thickness of 1 micron to 2 microns and comprises one of a silicon oxide material or a silicon nitride material.
16. A method, comprising: receiving a substrate comprising a first die and a second die adjacent to the first die, wherein a trench is between the first die and the second die, and wherein a third die is below the first die and the second die, wherein the third die is hybrid bonded to the first die and hybrid bonded to the second die; forming a layer on top surfaces of the first die and the second die; wherein the layer comprises silicon and nitrogen; forming a fill dielectric material in the trench; and attaching a lid on the first die and the second die.
17. The method of clause 16, wherein the layer comprises a thickness between 200 nm and 500 nm and is on a top surface of the fill dielectric material, and wherein the lid comprises a silicon dioxide layer coating that is fusion bonded to the fill dielectric material.
18. The method of clause 16, wherein the layer comprises a thickness between 1 micron and 2 microns and is on a top surface of the fill dielectric material, and wherein the lid comprises a silicon dioxide layer coating that is fusion bonded to the layer.
19. The method of clause 18, further comprising forming an oxide layer on the layer, wherein the layer comprises a thickness between 1 micron to 2 microns, and wherein the oxide layer comprises a thickness between 1 micron to 2 microns, wherein the lid comprises a silicon nitride layer coating that is fusion bonded to the oxide layer.
20. The method of clause 19, wherein a silicon nitride liner is on sidewalls of the first die and on sidewalls of the second die.

## Claims

1. An apparatus, comprising:
a first die on a first dielectric material and a second die on a second dielectric material, the first die adjacent to the second die;
a third die below the first die, the third die hybrid bonded to the first die;
a fourth die below the second die, the fourth die hybrid bonded to the second die;
a layer comprising nitrogen and silicon, the layer directly on a top surface of the first die and directly on a top surface of the second die;
a fill dielectric material between the first die and the second die; and
a lid over the fill dielectric material.

2. The apparatus of claim 1, wherein the layer comprises at least one of silicon nitride, a silicon oxynitride, a metal, or a metal alloy.

3. The apparatus of claim 1 or claim 2, wherein the layer comprises a thickness between 1 micron to 2 microns and is on the fill dielectric material between the first die and the second die, and wherein the lid comprises a lid liner, the lid liner bonded to the layer, wherein the lid liner comprises a silicon dioxide layer.

4. The apparatus of claim 3, wherein the layer comprises a first capping layer, and wherein a second capping layer is on the first capping layer, wherein the second capping layer comprises a silicon dioxide layer.

5. The apparatus of claim 4, wherein the lid comprises a lid liner, the lid liner bonded to the layer, wherein the lid liner comprises a silicon nitride layer, and wherein the second capping layer comprises a thickness of between 1 micron to 2 microns.

6. The apparatus of any one of claims 1-5 further comprising wherein the lid comprises a lid liner, the lid liner bonded to the fill dielectric material, wherein the lid liner comprises a silicon nitride layer, and wherein the fill dielectric material extends 1 micron to 2 microns above a surface of the first die and above a surface of the second die.

7. An apparatus, comprising:
a first die and a second die adjacent to the first die;
a third die below the first die and hybrid bonded to the first die;
a fourth die below the second die and hybrid bonded to the second die;
a fill dielectric material between the first die and the second die;
a capping layer on the fill dielectric material and on top surfaces of the first die and the second die, wherein the capping layer comprises silicon and nitrogen; and
a lid over the first die, the second die, and the fill dielectric material.

8. The apparatus of claim 7, wherein the fill dielectric material comprises silicon and oxygen, and has a lateral width between 20 microns and 20 mm, and wherein a silicon nitride liner is on sidewalls of the first die and on sidewalls of the second die.

9. The apparatus of any one of claims 7-8 further comprising wherein the silicon nitride liner comprises a thickness between 200 nm and 500 nm.

10. The apparatus of any one of claims 7-9, wherein the capping layer comprises a thickness of 1 micron to 2 microns and comprises one of a silicon oxide material or a silicon nitride material.

11. A method, comprising:
receiving a substrate comprising a first die and a second die adjacent to the first die, wherein a trench is between the first die and the second die, and wherein a third die is below the first die and the second die, wherein the third die is hybrid bonded to the first die and hybrid bonded to the second die;
forming a layer on top surfaces of the first die and the second die; wherein the layer comprises silicon and nitrogen;
forming a fill dielectric material in the trench; and
attaching a lid on the first die and the second die.

12. The method of claim 11, wherein the layer comprises at least one of silicon nitride, a silicon oxynitride, a metal, or a metal alloy.

13. The method of any one of claims 11-12, further comprising wherein the layer comprises a thickness between 1 micron and 2 microns and is on a top surface of the fill dielectric material, and wherein the lid comprises a silicon dioxide layer coating that is fusion bonded to the layer.

14. The method of any one of claims 11-13 further comprising forming an oxide layer on the layer, wherein the layer comprises a thickness between 1 micron to 2 microns, and wherein the oxide layer comprises a thickness between 1 micron to 2 microns, wherein the lid comprises a silicon nitride layer coating that is fusion bonded to the oxide layer.

15. The method of any one of claims 11-14 further comprising wherein a silicon nitride liner is on sidewalls of the first die and on sidewalls of the second die.
